# EUROPEAN PATENT SPECIFICATION

(11) **EP 1 806 613 B1**
(45) Date of publication and mention of the grant of the patent: **20.08.2008**
(21) Application number: 06252520.9
(22) Date of filing: 12.05.2006
(51) Int. Cl.: G02B 26/08, B81B 7/02

(54) **Two-axis micro optical scanner**
Zweiachsiger mikrooptischer Scanner
Lecteur optique avec micro à deux axes

(30) Priority: 10.01.2006 KR 20060002689
(43) Date of publication of application: 11.07.2007
(73) Proprietor: Samsung Electronics Co., Ltd., Suwon-si, Gyeonggi-do 442-742 (KR)
(72) Inventor: Jun-o, Kim, Sanghyeon-dong Yongin-si Gyeonggi-do (KR); Hwa-sun, Lee, Yeongtong-gu Suwon-Si Gyeonggi-do (KR)
(74) Representative: Greene, Simon Kenneth

(56) References cited:
- WO-A-01/73937
- WO-A-01/93930
- US-A1- 2001 051 014
- SCHENK H ET AL: "Micro-opto-electro-mechanical systems technology and its impact on photonic applications" JOURNAL OF MICROLITHOGRAPHY, MICROFABRICATION, AND MICROSYSTEMS SPIE-INT. SOC. OPT. ENG USA, vol. 4, no. 4, October 2005 (2005-10), pages 41501-1-41501-11, XP002423113 ISSN: 1537-1646

## Description

The present invention relates to a two-axis micro scanner, and more particularly, to a two-axis micro scanner in which horizontal driving required for high frequency motion uses a vertical comb-type electrode structure and vertical driving required for low frequency motion uses a piezo-actuator.

A micro scanner formed using micro-electro-mechanical system (MEMS) technology generally includes a vertical comb-type electrode structure in which moving comb-electrodes (or a rotor) and static comb-electrode (or a stator) are respectively formed on upper and lower portions of a silicon-on-insulator (SOI) substrate.

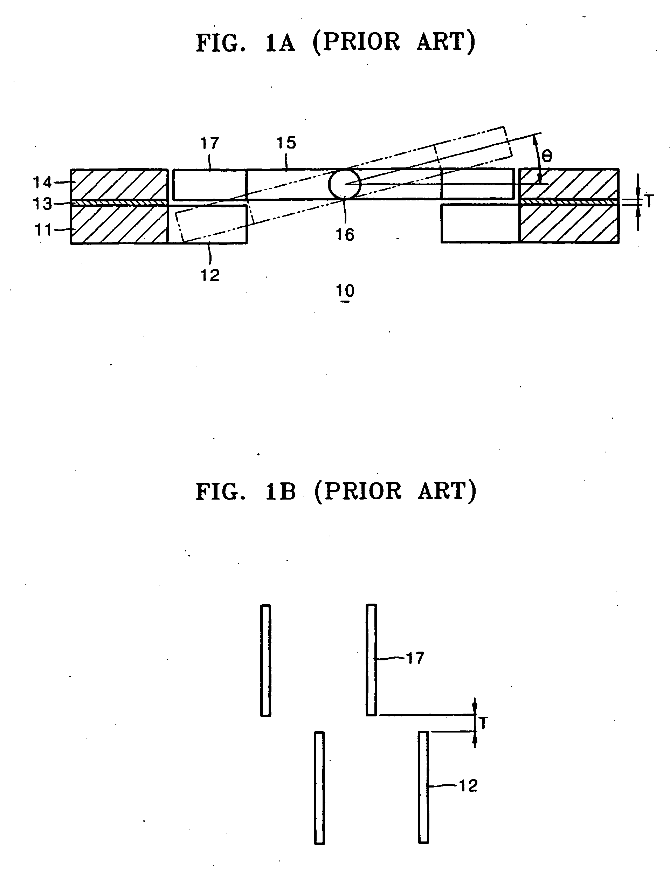

FIG. 1A is a cross-sectional view of a vertical comb-type electrode structure in a conventional micro scanner 10. FIG. 1B illustrates relative positions of static comb-electrodes and moving comb-electrodes in the vertical comb-type electrode structure of the micro scanner of FIG. 1A. Referring to FIG. 1A, the micro scanner 10 has a structure in which a upper silicon substrate 14 having moving comb-electrodes 17 is stacked on a lower silicon substrate 11 having static comb-electrodes 12. An insulation layer 13 formed of, for example, oxide such as SiO₂ is formed between the upper and lower silicon substrates 11 and 14. A plurality of moving comb-electrodes 17 are vertically formed on opposite sides of the micro mirror 15. In addition, a plurality of static comb-electrodes 12 are vertically formed in the lower silicon substrate 11. Referring to FIG. 1B, a plurality of static comb-electrodes 12 are arranged to alternate with a plurality of the moving comb-electrodes 17. In this structure, voltages are applied to the moving comb-electrodes 17 and the static comb-electrodes 12, and thus the moving comb-electrodes 17 move toward spaces between the static comb-electrodes 12 due to electrostatic force between the moving comb-electrodes 17 and the static comb-electrodes 12. Accordingly, the micro mirror 15 rotates about an axis 16.

A micro scanner can be used to scan an image on a screen in, for example, a laser TV. In this case, to scan an image onto the entire screen, the image should be scanned in a horizontal direction and a vertical direction.

Conventionally, two micro scanners are used to respectively scan an image in the horizontal direction and the vertical direction. However, recently, a single two-axis micro scanner that drives in horizontal and vertical directions can scan images in the horizontal direction and the vertical direction. In the two-axis micro scanner, the horizontal driving shows a high frequency motion of about 25 kHz, and the vertical driving shows a low frequency motion of about 60 Hz. For these motions, the inherent resonant frequency of the micro mirror 15 should be equal to the horizontal driving frequency so that the high frequency resonant driving is performed according to the resonant frequency of the micro mirror 15 in the horizontal direction. However, in the vertical direction, low frequency non-resonant driving is performed.

The vertical comb-type electrode structure illustrated in FIGS. 1A and 1B is more suited to high frequency horizontal driving which is the resonant driving than for the low frequency vertical driving which is the non-resonant driving. For example, the driving force generated between the moving comb-electrodes 17 and the static comb-electrodes 12 is proportional to voltage squared so that a voltage having a square root (SQRT) waveform should be generated to linearly drive the micro mirror 15. However, since the voltage having a SQRT waveform includes a voltage component of a waveform corresponding to the resonant frequency of the micro mirror 15, the micro mirror 15 does not simply move linearly at a low frequency, but moves in a complex manner with the combination of the low frequency and the resonant high frequency.

Referring to FIGS. 1A and 1B, since a gap (T) typically exists between the moving comb-electrodes 17 and the static comb-electrodes 12 in the vertical direction, the initial driving force may be reduced. That is, when the moving comb-electrode 17 overlaps the static comb-electrodes 12, the driving force is linearly generated. Accordingly, the micro mirror 15 may not be linearly driven in an initial stage until the voltage difference between the moving comb-electrodes 17 and the static comb-electrodes 12 is greater than a threshold value. In addition, the non-smooth electrostatic force acting in the comb electrode while passing the gap may generate an undesirable short oscillation in the scanner motion, which deviates the scanner from linear motion.

The present invention provides a two-axis micro scanner in which horizontal driving required for high frequency motion uses a vertical comb-type electrode structure and vertical driving required for low frequency motion uses a piezo-actuator.

According to an aspect of the present invention, there is provided a micro scanner according to claim 1.

A plurality of cantilevers may include: first and second cantilevers respectively extending from opposite sides of the frame and connected to a first end of the horizontal driving unit; and third and fourth cantilevers respectively extending from opposite sides of the frame and connected to a second end of the horizontal driving unit.

The micro scanner may further include: a first connector connecting a first end of the horizontal driving unit and facing ends of the first and second cantilevers; and a second connector connecting a second end of the horizontal driving unit and facing ends of the third and fourth cantilevers.

The first cantilever may be bent in the same direction as the second cantilever, the third cantilever maybe bent in the same direction as the fourth cantilever, and the bending directions of the first and second cantilevers may be opposite to those of the third and fourth cantilevers.

A plurality of cantilevers may include: first and third cantilevers extending perpendicular to each other from a first corner of the frame; and second and fourth cantilevers extending perpendicular to each other from a second corner of the frame and respectively perpendicularly connected to the first and third cantilevers.

Here, a first end of the horizontal driving unit may be connected to a contact portion connecting the first and second cantilevers, and a second end of the horizontal driving unit may be connected to a contact portion connecting the third and fourth cantilevers.

In this case the micro scanner may further include: a first connector connecting a first end of the horizontal driving unit and the contact portion connecting the first and second cantilevers; and a second connector connecting a second end of the horizontal driving unit and the contact portion connecting the third and fourth cantilevers.

A portion of each of the cantilevers on which a corresponding piezo-actuator is disposed may be thinner than other portions thereof.

The portion of each of the cantilevers on which a corresponding piezo-actuator is disposed may be cut.

The piezo-actuator may have a multi-layered structure in which a first piezoelectric device, a second electrode, a second piezoelectric device and a third electrode are sequentially stacked on a first electrode.

The frame may include a lower silicon substrate, an insulation layer formed on the lower silicon substrate, and an upper silicon substrate formed on the insulation layer.

The micro mirror, the moving comb-electrodes, and the cantilevers may be formed in the same plane as the upper silicon substrate, and the static comb-electrodes are formed in the same plane as the lower silicon substrate.

A plurality of cantilevers may include: first and second cantilevers extending parallel to each other from a first side of the frame and connecting the opposite sides of the horizontal driving unit; and third and fourth cantilevers extending parallel to each other from a second side of the frame and connecting the opposite sides of the horizontal driving unit.

Distances from centers of the opposite sides of the horizontal driving unit to the first and second cantilevers may be respectively equal to distances from centers of the opposite sides of the horizontal driving unit to the third and fourth cantilevers.

The above and other features and advantages of the present invention will become more apparent by describing in detail exemplary embodiments thereof with reference to the attached drawings in which:
FIG. 1A is a cross-sectional view of a vertical comb-type electrode structure in a conventional micro scanner;
FIG. 1B illustrates relative positions of static comb-electrodes and moving comb-electrodes in the vertical comb-type electrode structure of the micro scanner of FIG. 1A;
FIG. 2A is a plan view of a two-axis micro scanner according to an embodiment of the present invention;
FIG. 2B is a cross-sectional view of the two-axis micro scanner of FIG. 2A, taken along a line A-A';
FIGS. 3A through 3C are cross-sectional views illustrating a principle of vertical driving using piezo-actuators in the two-axis micro scanner of FIGS. 2A and 2B according to an embodiment of the present invention;
FIGS. 4 and 5 illustrate piezo-actuators according to other embodiments of the present invention;
FIG. 6 is a plan view of a two-axis micro scanner according to another embodiment of the present invention;
FIG. 7 a plan view of a two-axis micro scanner according to another embodiment of the present invention; and
FIG. 8 a plan view of a two-axis micro scanner according to another embodiment of the present invention.

Hereinafter, the present invention will be described more fully with reference to the accompanying drawings, in which exemplary embodiments of the invention are shown.

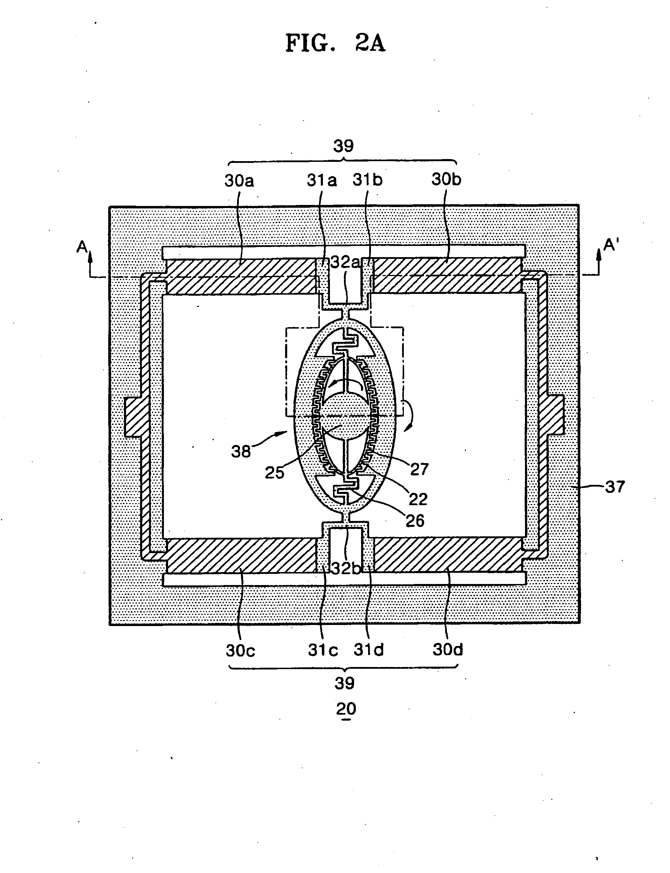

FIG. 2A is a plan view of a two-axis micro scanner 20 according to an embodiment of the present invention. Referring to FIG. 2A, the two-axis micro scanner 20 includes a frame 37, a micro mirror 25, a plurality of moving comb-electrodes 27, a plurality of static comb-electrodes 22, first through fourth cantilevers 31.a through 31d, and a plurality of piezo-actuators 30a through 30d.

Like the conventional art, a plurality of static comb-electrodes 22 and the moving comb-electrodes 27 have vertical comb-type electrode structures to resonantly drive the micro mirror 25. Referring to FIG. 2A, the plurality of moving comb-electrodes 27 are vertically aligned and are disposed parallel to each other along opposite sides of the micro mirror 25. In addition, the static comb-electrodes 22 are vertically aligned and are disposed parallel to each other to alternate with the plurality of moving comb-electrodes 27. Accordingly, due to electrostatic force between the plurality of static comb-electrodes 22 and the moving comb-electrodes 27, the micro mirror 25 rotates like a see-saw at a high frequency of several to tens of kHz, for example, about 25kHz. For the see-saw movement, the micro mirror 25 is suspended by springs 26 disposed at opposites ends thereof. The springs 26 act as a rotation axis for the micro mirror 25, and provide an elastic restoring force to the micro mirror 25. According to the current embodiment of the present invention, the vertical comb-type electrode structure is used only to drive the micro mirror 25 in the horizontal scanning direction. Hereinafter, the micro mirror 25, the static comb-electrodes 22, the moving comb-electrodes 27, and the springs 26 are referred to as a horizontal driving unit 38.

In the current embodiment of the present invention, the first through fourth cantilevers 31a through 31d and the plurality of piezo-actuators 30a through 30d are used to linearly drive the micro mirror 25 in the vertical scanning direction. Referring to FIG. 2A, the first through fourth cantilevers 31a through 31d vertically extend from one inner side of the frame 37 to connect opposite ends of the horizontal driving unit 38. The first through fourth cantilevers 31a through 31d support and suspend the horizontal driving unit 38 in the frame 37. More specifically, the first cantilever 31a vertically extends from the left inner side of the frame 37 to connect an upper end of the horizontal driving unit 38, and the second cantilever 31b facing the first cantilever 31a vertically extends from the right inner side of the frame 37 to connect the upper end of the horizontal driving unit 38. In addition, the third cantilever 31c vertically extends from the left inner side of the frame 37 to connect a lower end of the horizontal driving unit 38 and the fourth cantilever 31d facing the third cantilever 31c vertically extends from the right inner side of the frame 37 to connect the lower end of the horizontal driving unit 38. That is, the first cantilever 31a and the second cantilever 31b vertically extend from two respective opposing sides of the frame 37 to connect the upper end of the horizontal driving unit 38, and the third cantilever 31c and the fourth cantilever 31d vertically extend from two respective opposing sides of the frame 37 to connect the lower end of the horizontal driving unit 38. In addition, the first and third cantilevers 31a and 31c are disposed on the same lines of the second and fourth cantilevers 31b and 31d, respectively. The positions of the first and second cantilevers 31a and 31b are symmetric to the positions of the third and fourth cantilevers 31c and 31d with respect to the center of the side of the horizontal driving unit 38.

The first through fourth cantilevers 31a through 31d may be connected to the horizontal driving unit 38 in a direct manner or through corresponding first and second connectors 32a and 32b as illustrated in FIG. 2A. For example, the first connector 32a connects the opposite ends of the first and second cantilevers 31a and 31b with the upper portion of the horizontal driving unit 38, and the second connector 32b connects the opposite ends of the third and fourth cantilevers 31c and 31d and the lower portion of the horizontal driving unit 38.

The piezo-actuators 30a through 30d are respectively installed on upper surfaces of the first through fourth cantilevers 31a through 31d. A plurality of piezo-actuators 30a through 30d contract or expand according to the direction of the voltage application, and thus the first through fourth cantilevers 31a through 31d bend upward or downward. Accordingly, the first through fourth cantilevers 31a through 31d and the piezo-actuators 30a through 30d form a vertical driving unit 39 driving the micro mirror 25 in the vertical scanning direction.

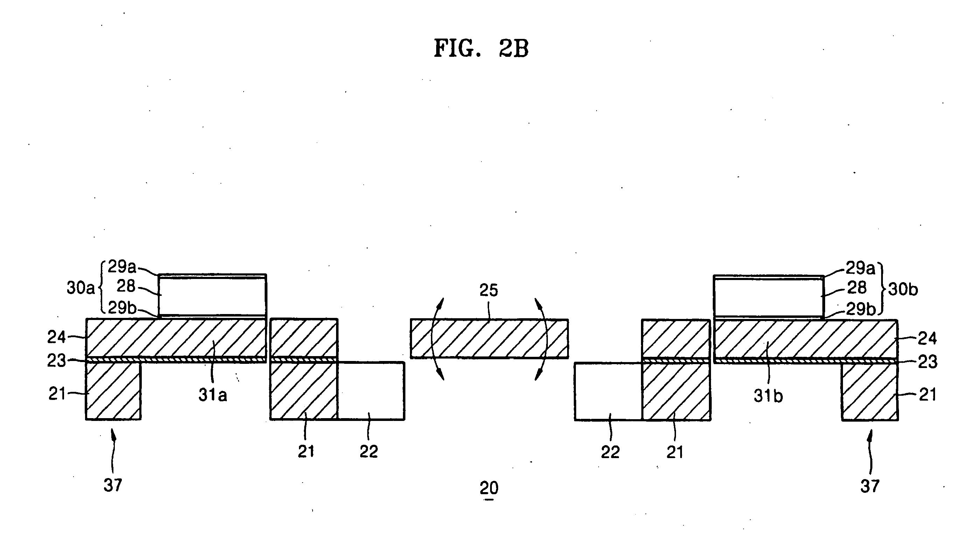

FIG. 2B is a cross-sectional view of the two-axis micro scanner 20 of FIG. 2A, taken along a line A-A'. Like the conventional art, the micro scanner 20 according to the present embodiment may be integrally formed by etching a silicon-on-insulator (SOI) substrate in which an oxide insulation layer 23 formed of, for example, SiO₂, is disposed between a lower silicon substrate 21 and an upper silicon substrate 24. That is, an inside of the SOI substrate is etched to form of the first through fourth cantilevers 31a through 31d, the first and second connectors 32a and 32b, the static comb-electrodes 22, the moving comb-electrodes 27, the micro mirror 25, and the springs 26. In addition, the outer edge of the SOI is not etched to form the frame 37. For example, as illustrated in FIG. 2B, the first through fourth cantilevers 31a through 31d, the first and second connectors 32a and 32b, the micro mirror 25, the springs 26, and the moving comb-electrodes 27 are formed from the upper silicon substrate 24, and the static comb-electrodes 22 are formed from the lower silicon substrate 21. After etching the SOI substrate, the piezo-actuators 30a through 30d are respectively formed on the first through fourth cantilevers 31a through 31d. Referring to FIG. 2B, the piezo-actuators 30a through 30d have structures in which upper and lower electrodes 29a and 29b are respectively formed on opposite sides of a piezoelectric device 28, for example, a PZT.

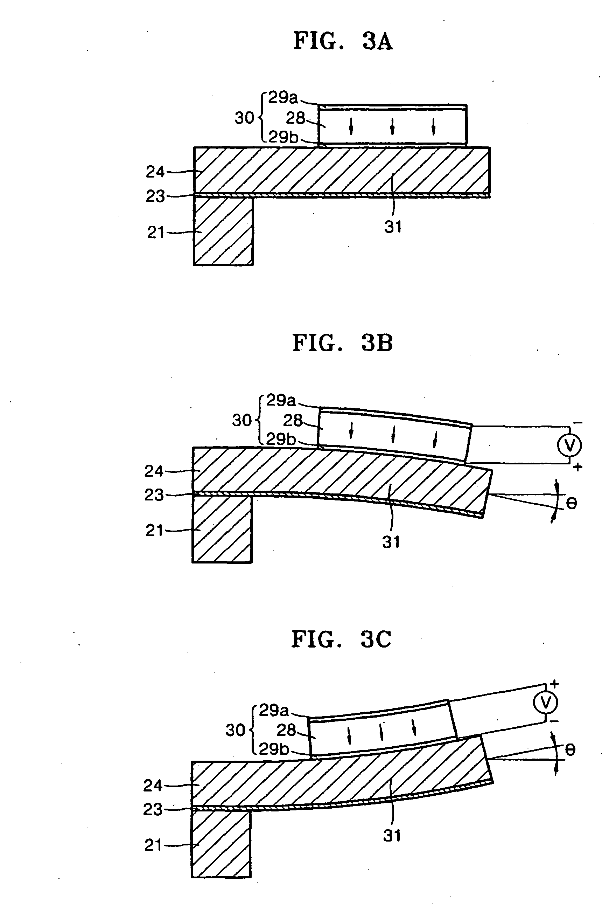

FIGS. 3A through 3C are cross-sectional views illustrating a principle of vertical driving using the piezo-actuators 30a through 30d in the two-axis micro scanner of FIGS. 2A and 2B. As described above, the piezo-actuators 30a through 30d have structures in which the upper and lower electrodes 29a and 29b are respectively formed on opposite sides of the piezoelectric device 28. In general, the piezoelectric device 28 is polarized in a predetermined direction by poling a ferroelectric material. Hereinafter, a cantilever 31 denotes one of the first through fourth cantilevers 31a through 31d, and a piezo-actuator 30 denotes one of the first through fourth piezo-actuator 30a through 30d in the following drawing. Referring to FIG. 3A, according to the current embodiment of the present invention, the piezoelectric device 28 is arranged to be vertically polarized. In FIG. 3A, the polarization direction of the piezoelectric device 28 is downward, but it may be upward.

When an electric field having the same direction as the polarization direction of the piezoelectric device 28 is applied, the piezoelectric device 28 contracts. When an electric field having the opposite direction to the polarization direction of the piezoelectric device 28 is applied, the piezoelectric device 28 expands. Referring to FIG. 3B, when a negative voltage is applied to the upper electrode 29a and a positive voltage is applied to the lower electrode 29b, the piezoelectric device 28 expands. Accordingly, the upper surface of the cantilever 31 on which the piezo-actuator 30 is installed expands with the piezoelectric device 28. Accordingly, the upper surface of the cantilever 31 becomes longer than the lower surface thereof, and thus the cantilever 31 is downwardly slanted. Otherwise, when a positive voltage is applied to the upper electrode 29a and a negative voltage is applied to the lower electrode 29b, the piezoelectric device 28 contracts. Accordingly, the upper surface of the cantilever 31 on which the piezo-actuator 30 is installed contracts with the piezoelectric device 28. Accordingly, the upper surface of the cantilever 31 becomes shorter than the lower surface thereof, and thus the cantilever 31 is upwardly slanted. The slant angle of the cantilever 31 is proportional to the magnitude of the voltage applied to the piezoelectric device 28.

Accordingly, the micro mirror 25 can be linearly driven in the vertical direction by operating the vertical driving unit 39. Referring to FIG. 2A, if all of the polarization directions of piezoelectric devices in the first through fourth piezo-actuators 30a through 30d are equally arranged, when the same directional voltages are applied to the first and second piezo-actuators 30a and 30b, and the opposite directional voltages are applied to the third and fourth piezo-actuators 30c and 30d, the first and second cantilevers 31a and 31b are oppositely bent to the bending direction of the third and fourth cantilevers 31c and 31d. For example, the first and second cantilevers 31a and 31b are upwardly bent, but the third and fourth cantilevers 31c and 31d are downwardly bent. Accordingly, the upper portion of the horizontal driving unit 38 connected to the first through fourth cantilevers 31a through 31d moves upwardly, but the lower portion of the horizontal driving unit 38 moves downwardly. When the directions of the applied voltage are changed, the first and second cantilevers 31a and 31b are downwardly bent, but the third and fourth cantilevers 31c and 31d are upwardly bent. Accordingly, the upper portion of the horizontal driving unit 38 moves downwardly, but the lower portion thereof moves upwardly. In addition, if the polarization directions of the piezoelectric devices in the first and second piezo-actuators 30a and 30b are opposite to the polarization directions of the piezoelectric devices in the third and fourth piezo-actuators 30c and 30d, the above-described movements can be obtained by applying voltages having the same directions. In this manner, the micro mirror 25 can be linearly driven in the vertical direction.

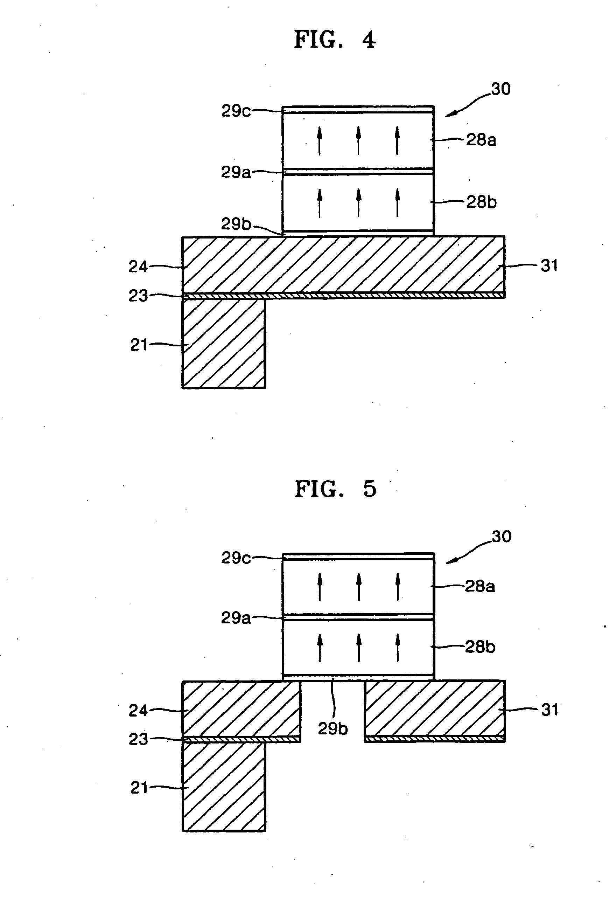

Meanwhile, if the cantilever 31 is formed of silicon, greater force may be required for the contraction/expansion of the cantilever 31 and the bending caused by the contraction/expansion. Accordingly, as illustrated in FIG. 4, the piezo-actuator 30 can be formed using two piezoelectric devices 28a and 28b. In this case, an upper piezoelectric device 28a and a lower piezoelectric device 28b have the same polarization direction. The same directional voltages are applied to lower and upper electrodes 29b and 29c, but the opposite directional voltage is applied to a middle electrode 29a. Accordingly, the upper and lower piezoelectric devices 28a and 28b contract or expand simultaneously. According to the embodiment of the present invention illustrated in FIG. 4, the piezo-actuator 30 includes two piezoelectric devices, but more piezoelectric devices can be employed.

Referring to FIG. 5, a portion of the cantilever 31 on which the piezo-actuator 30 is disposed may be cut so that the cantilever 31 can be easily bent. According to the embodiment of the present invention illustrated in FIG. 5, a portion of the cantilever 31 is completely cut, but the portion of the cantilever 31 on which the piezo-actuator 30 is disposed can be thinner than other portions.

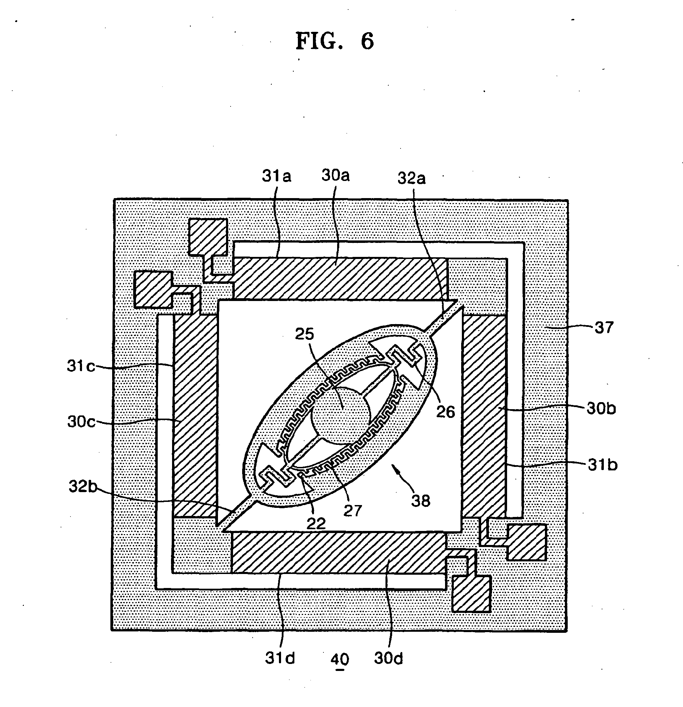

FIG. 6 is a plan view of a two-axis micro scanner 40 according to another embodiment of the present invention. Referring to FIG. 6, in the two-axis micro scanner 40, first through fourth cantilevers 31a through 31d are respectively formed parallel to inner sides of a frame 37, thereby forming a rectangular shape. a horizontal driving unit 38 is arranged in a diagonal direction. More specifically, as illustrated in FIG. 6, the first and third cantilevers 31a and 31c are perpendicularly connected to each other at a corner of the frame 37. The second and fourth cantilevers 31b and 31d are perpendicularly connected to each other at a diagonally opposite corner of the frame 37. The first and second cantilevers 31a and 31b are perpendicularly connected to each other at another corner of the frame 37. Similarly, the third and fourth cantilevers 31b and 31d are perpendicularly connected each other at another corner of the frame 37. Piezo-actuators 30a through 30d are respectively disposed on upper surfaces of the first through fourth cantilevers 31a through 31d.

One end of a horizontal driving unit 38 is connected to the first and second cantilevers 31a and 31b through a first connector 32a. The other end of the horizontal driving unit 38 is connected to the third and fourth cantilevers 31c and 31d through a second connector 32b. Accordingly, the horizontal driving unit 38 is diagonally supported and suspended in the frame 37. Compared with FIG. 2A, since the horizontal driving unit 38 is diagonally connected to the frame 37, the entire size of the frame 37 can be reduced. The present embodiment in FIG. 6 has the same configuration as in FIG. 2A, except for the arrangement of the first through fourth cantilevers 31a through 31d and the horizontal driving unit 38.

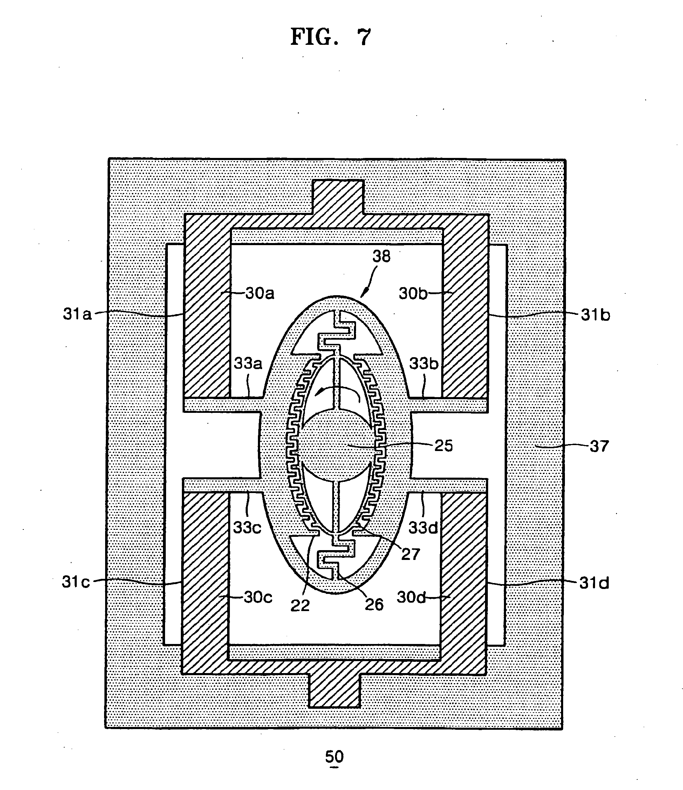

FIG. 7 a plan view of a two-axis micro scanner 50 according to another embodiment of the present invention. Referring to FIG. 7, in the two-axis micro scanner 50, first through fourth cantilevers 31a through 31d extending from a frame 37 are connected to opposite sides of a horizontal driving unit 38. More specifically, the first and second cantilevers 31a and 31b extend parallel to each other from, for example, upper sides of the frame 37 to respectively connect opposite sides of the horizontal driving unit 38, as illustrated in FIG. 7. In addition, the third and fourth cantilevers 31c and 31d extend parallel to each other from lower sides of the frame 37 to respectively connect opposite sides of the horizontal driving unit 38. The first through fourth cantilevers 31a through 31d may be connected to the horizontal driving unit 38 in a direct manner or through corresponding first through fourth connectors 33a through 33d. In addition, piezo-actuators 30a through 30d are respectively disposed on upper surfaces of the first through fourth cantilevers 31a through 31d.

The contact portions between the first through fourth cantilevers 31a through 31d and the horizontal driving unit 38 deviate vertically from the centers of the opposite sides of the horizontal driving unit 38. For example, the contact portions between the first and second cantilevers 31a and 31b and the horizontal driving unit 38 deviate upwardly from the centers of the sides of the horizontal driving unit 38. The contact portions between the third and fourth cantilevers 31c and 31d and the horizontal driving unit 38 deviate downwardly from the centers of the sides of the horizontal driving unit 38. As illustrated in FIG 7, the distances from the centers of the opposite sides of the horizontal driving unit 38 to the first and second cantilevers 31a and 31b are respectively equal to the distances from the centers of the opposite sides of the horizontal driving unit 38 to the third and fourth cantilevers 31c and 31d. That is, the first and second cantilevers 31a and 31b are symmetrical to the third and fourth cantilevers 31c and 31d with respect to the centers of the opposite sides of the horizontal driving unit 38. The present embodiment in FIG. 7 has the same configuration as in FIG. 2A, except for the arrangement of the first through fourth cantilevers 31 a through 31d and the horizontal driving unit 38. In the present embodiment in FIG. 7, although the bending angles of the first through fourth cantilevers 31a through 31d are relatively small, the driving angle can be large in the vertical direction.

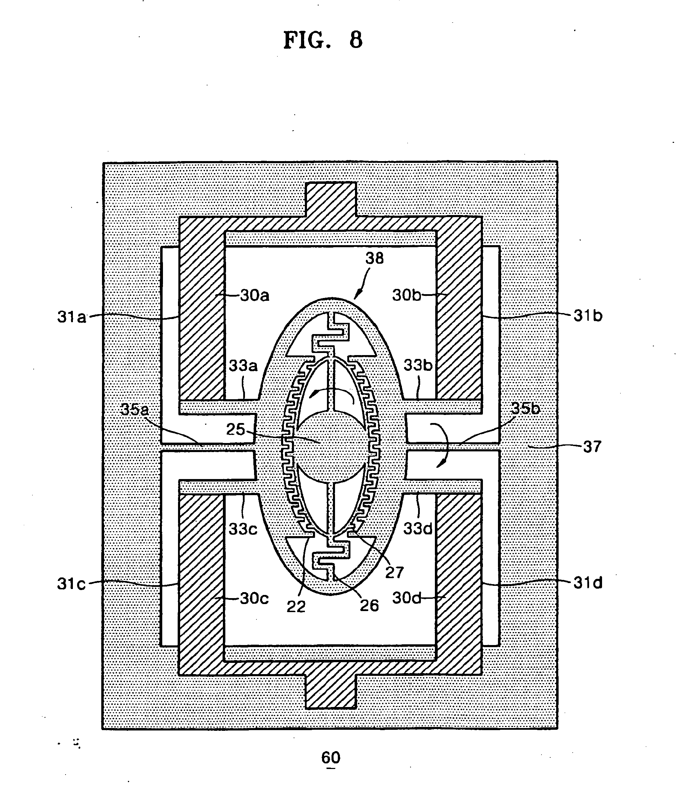

FIG. 8 a plan view of a two-axis micro scanner 60 according to another embodiment of the present invention. Referring to FIG. 8, the two-axis micro scanner 60 further includes first and second torsion springs 35a and 35b extending from the centers of opposites sides of a horizontal driving unit 38 toward inner facing sides of a frame 37. That is, the first torsion spring 35a connects the left side of the frame 37 to the center of the left side of the horizontal driving unit 38, and the second torsion spring 35b connects the right side of the frame 37 to the center of the right side of the horizontal driving unit 38. The first and second torsion springs 35a and 35b act as a rotation axis when the horizontal driving unit 38 is driven in a vertical direction, and provide an elastic restoring force. Accordingly, using the first and second torsion springs 35a and 35b, the vertical driving becomes more stable. Although not illustrated, the micro scanner 20 of FIG. 2A may further include the above described torsion springs.

The micro scanner of the present invention uses a vertical comb-type electrode structure resonantly moving for performing high frequency horizontal driving, and a cantilever and a piezo-actuator non-resonantly moving for performing low frequency vertical driving. Using the cantilever and the piezo-actuator, stable and linear vertical driving can be obtained.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A micro scanner comprising:
a frame (37);
a horizontal driving unit (38) framing and comprising
a micro mirror (25),
a plurality of vertical moving comb-electrodes (27) formed parallel to each other along opposite sides of the micro mirror,
a plurality of vertical static comb-electrodes (22) formed to alternate with the moving comb-electrodes,
two springs (26) disposed at opposite ends of the micro mirror linking the moving comb-electrodes (27) and the micro mirror (25) to the plurality of vertical static comb-electrodes (22), wherein the vertical moving comb-electrodes and the vertical static comb-electrodes are formed to rotate the micro mirror about a first axis; and
a vertical driving unit (39) comprising a plurality of cantilevers (31 a, 31 b, 31 c, 31 d) extending from the frame (37) and respectively connecting opposite ends or sides of the horizontal driving unit (38) to support the horizontal driving unit, and
a piezo-actuator (30a, 30b, 30c, 30d) installed on an upper surface of each of the cantilevers (31 a, 31 b, 31 c, 31 d), wherein the cantilevers (31 a, 31 b, 31 c, 31d) are arranged to be upwardly or downwardly bent according to contraction or expansion of the piezo-actuators, wherein the cantilevers and the respective piezo-actuators are formed to rotate the horizontal driving unit about a second axis which is substantially orthogonal to the first axis.

2. A micro scanner according to claim 1 wherein the cantilevers connect opposite ends of the horizontal driving unit.

3. The micro scanner of claim 2, wherein the plurality of cantilevers comprises:
first and second cantilevers (31 a, 31 b) respectively extending from opposite sides of the frame and connected to a first end of the horizontal driving unit; and
third and fourth cantilevers (31c, 31d) respectively extending from opposite sides of the frame and connected to a second end of the horizontal driving unit (38).

4. The micro scanner of claim 3, further comprises:
a first connector (32a) connecting a first end of the horizontal driving unit (38) and facing ends of the first and second cantilevers (31 a, 31 b); and
a second connector (32b) connecting a second end of the horizontal driving unit (38) and facing ends of the third and fourth cantilevers (31c, 31d).

5. The micro scanner of claim 3 or 4, wherein the first cantilever (31 a) is arranged to be bent in the same direction as the second cantilever (31 b), the third cantilever (31c) is bent in the same direction as the fourth cantilever (31d), and the bending directions of the first and second cantilevers are opposite to those of the third and fourth cantilevers.

6. The micro scanner of claim 2, wherein the plurality of cantilevers comprise:
first and third cantilevers (31a, 31 c) extending perpendicular to each other from a first corner of the frame; and
second and fourth cantilevers (31 b, 31d) extending perpendicular to each other from a second corner of the frame and respectively perpendicularly connected to the first and third cantilevers.

7. The micro scanner of claim 6, wherein a first end of the horizontal driving unit (38) is connected to a contact portion connecting the first and second cantilevers (31 a, 31 b), and a second end of the horizontal driving unit is connected to a contact portion connecting the third and fourth cantilevers (31c, 31d).

8. The micro scanner of claim 7, further comprising:
a first connector (32a) connecting a first end of the horizontal driving unit and the contact portion connecting the first and second cantilevers; and
a second connector (32b) connecting a second end of the horizontal driving unit and the contact portion connecting the third and fourth cantilevers.

9. The micro scanner of claim 6, 7 or 8, wherein the first cantilever (31 a) is arranged to be bent in the same direction as the second cantilever (31 b), the third cantilever (31 c) is arranged to be bent in the same direction as the fourth cantilever (31d), and the bending directions of the first and second cantilevers are opposite to those of the third and fourth cantilevers.

10. The micro scanner of any preceding claim, wherein a portion of each of the cantilevers (31 a, 31 b, 31 c, 31 d) on which a corresponding piezo-actuator is disposed is thinner than other portions thereof.

11. The micro scanner of any of claims 1 to 9, wherein the portion of each of the cantilevers (31 a, 31 b, 31 c, 31 d) on which a corresponding piezo-actuator is disposed is cut.

12. The micro scanner of claim 11, wherein the piezo-actuator (30) has a multi-layered structure in which a first piezoelectric device (28a), a second electrode (29a), a second piezoelectric device (28b) and a third electrode (29c) are sequentially stacked on a first electrode (29b).

13. The micro scanner of any preceding claim, wherein the frame comprises a lower silicon substrate (21), an insulation layer (23) formed on the lower silicon substrate, and an upper silicon substrate (24) formed on the insulation layer.

14. The micro scanner of claim 12, wherein the micro mirror (25), the moving comb-electrodes (27), and the cantilevers (31) are formed in the same plane as the upper silicon substrate (24), and the static comb-electrodes (22) are formed in the same plane as the lower silicon substrate (21).

15. A micro scanner according to claim 1 wherein the cantilevers (31) respectively connect opposite sides of the horizontal driving unit to support the horizontal driving unit.

16. The micro scanner of claim 15, wherein the plurality of cantilevers comprises:
first and second cantilevers (31a, 31 b) extending parallel to each other from a first side of the frame and connecting the opposite sides of the horizontal driving unit; and
third and fourth cantilevers (31c, 31d) extending parallel to each other from a second side of the frame and connecting the opposite sides of the horizontal driving unit.

17. The micro scanner of claim 16, wherein distances from centers of the opposite sides of the horizontal driving unit (38) to the first and second cantilevers (31 a, 31 b) are respectively equal to distances from centers of the opposite sides of the horizontal driving unit (38) to the third and fourth cantilevers (31c, 31d).

18. The micro scanner of claim 17, wherein the first cantilever (31a) is bent in the same direction as the second cantilever (31b), the third cantilever (31c) is bent in the same direction as the fourth cantilever (31d), and the bending directions of the first and second cantilevers are opposite to those of the third and fourth cantilevers.

19. The micro scanner of claim 15, wherein a portion of each of the cantilevers (31a, 31 b, 31 c, 31 d) on which a corresponding piezo-actuator is disposed is thinner than other portions thereof.

20. The micro scanner of claim 15, wherein the portion of each of the cantilevers (31a, 31 b, 31 c, 31 d) on which a corresponding piezo-actuator is disposed is cut.

21. The micro scanner of claim 20, wherein the piezo-actuator has a multi-layered structure in which a first piezoelectric device (28a), a second electrode (29a), a second piezoelectric device (28b) and a third electrode (29c) are sequentially stacked on a first electrode (29b), and the first piezoelectric device has an opposite polarization direction to the second piezoelectric device.

22. The micro scanner of claim 15, wherein the frame comprises a lower silicon substrate (21), an insulation layer (23) formed on the lower silicon substrate, and an upper silicon substrate (24) formed on the insulation layer.

23. The micro scanner of claim 22, wherein the micro mirror (25), the moving comb-electrodes (27), and the cantilevers (31 a, 31b, 31 c, 31 d) are formed in the same plane as the upper silicon substrate (24), and the static comb-electrodes (22) are formed in the same plane as the lower silicon substrate (21).

## Patentansprüche

1. Mikroscanner umfassend:
einen Rahmen (37),
eine horizontale Antriebseinheit (38), die folgendes einrahmt und umfasst:
einen Mikrospiegel (25),
eine Mehrzahl von vertikal beweglichen Kammelektroden (27), die parallel zueinander entlang gegenüberliegender Seiten des Mikrospiegels ausgebildet sind,
eine Mehrzahl von vertikalen statischen Kammelektroden (22), die so ausgebildet sind, dass sie sich mit den beweglichen Kammelektroden abwechseln, und
zwei Federn (26), die an gegenüberliegenden Enden des Mikrospiegels so angeordnet sind, dass sie die beweglichen Kammelektroden (27) und den Mikrospiegel (25) mit der Mehrzahl von vertikalen statischen Kammelektroden (22) verbinden, wobei die vertikal beweglichen Kammelektroden und die vertikalen statischen Kammelektroden so ausgebildet sind, dass sie den Mikrospiegel um eine erste Achse drehen, und
eine vertikale Antriebseinheit (39) umfassend eine Mehrzahl von Cantilevern (31a, 31b, 31c, 31d), die sich vom Rahmen (37) erstrecken und jeweils gegenüberliegende Enden oder Seiten der horizontalen Antriebseinheit (38) verbinden, um die horizontale Antriebseinheit zu tragen, und
einen Piezoaktuator (30a, 30b, 30c, 30d), der auf einer Oberseite jedes der Cantilever (31 a, 31 b, 31 c, 31 d) installiert ist, wobei die Cantilever (31 a, 31 b, 31 c, 31 d) so ausgebildet sind, dass sie gemäß einer Kontraktion oder Expansion der Piezoaktuatoren nach oben oder unten gebogen werden, wobei die Cantilever und die zugehörigen Piezoaktuatoren so ausgebildet sind, dass sie die horizontale Antriebseinheit um eine zweite Achse drehen, die im Wesentlichen orthogonal zur ersten Achse ist.

2. Mikroscanner nach Anspruch 1, wobei die Cantilever gegenüberliegende Enden der horizontalen Antriebseinheit verbinden.

3. Mikroscanner nach Anspruch 2, wobei die Mehrzahl von Cantilevern umfasst:
erste und zweite Cantilever (31 a, 31 b), die sich jeweils von gegenüberliegenden Seiten des Rahmens erstrecken und mit einem ersten Ende der horizontalen Antriebseinheit verbunden sind, und
dritte und vierte Cantilever (31 c, 31 d), die sich jeweils von gegenüberliegenden Seiten des Rahmens erstrecken und mit einem zweiten Ende der horizontalen Antriebseinheit (38) verbunden sind.

4. Mikroscanner nach Anspruch 3, ferner umfassend:
eine erste Verbindungseinrichtung (32a), die ein erstes Ende der horizontalen Antriebseinheit (38) und zugewandte Enden der ersten und zweiten Cantilever (31 a, 31 b) verbindet, und
eine zweite Verbindungseinrichtung (32b), die ein zweites Ende der horizontalen Antriebseinheit (38) und zugewandte Enden der dritten und vierten Cantilever (31 c, 31 d) verbindet.

5. Mikroscanner nach Anspruch 3 oder 4, wobei der erste Cantilever (31a) so ausgebildet ist, dass er in die gleiche Richtung wie der zweite Cantilever (31 b) gebogen wird, der dritte Cantilever (31 c) in die gleiche Richtung wie der vierte Cantilever (31 d) gebogen wird und die Biegerichtungen der ersten und zweiten Cantilever zu denen der dritten und vierten Cantilever entgegengesetzt sind.

6. Mikroscanner nach Anspruch 2, wobei die Mehrzahl von Cantilevern umfasst:
erste und dritte Cantilever (31 a, 31 c), die sich senkrecht zueinander von einer ersten Ecke des Rahmens erstrecken, und
zweite und vierte Cantilever (31 b, 31 d), die sich senkrecht zueinander von einer zweiten Ecke des Rahmens erstrecken und jeweils senkrecht mit dem ersten und dritten Cantilever verbunden sind.

7. Mikroscanner nach Anspruch 6, wobei ein erstes Ende der horizontalen Antriebseinheit (38) mit einem Kontaktteil verbunden ist, der den ersten und zweiten Cantilever (31 a, 31 b) verbindet, und ein zweites Ende der horizontalen Antriebseinheit mit einem Kontaktteil verbunden ist, der den dritten und vierten Cantilever (31 c, 31 d) verbindet.

8. Mikroscanner nach Anspruch 7, ferner umfassend:
eine erste Verbindungseinrichtung (32a), die ein erstes Ende der horizontalen Antriebseinheit mit dem Kontaktteil verbindet, der den ersten und zweiten Cantilever verbindet, und
eine zweite Verbindungseinrichtung (32b), die ein zweites Ende der horizontalen Antriebseinheit mit dem Kontaktteil verbindet, der den dritten und vierten Cantilever verbindet.

9. Mikroscanner nach Anspruch 6, 7 oder 8, wobei der erste Cantilever (31 a) so ausgebildet ist, dass er in die gleiche Richtung gebogen wird wie der zweite Cantilever (31 b), der dritte Cantilever (31c) so ausgebildet ist, dass er in die gleiche Richtung gebogen wird wie der vierte Cantilever (31 d), und die Biegerichtungen des ersten und zweiten Cantilevers zu denen des dritten und vierten Cantilevers entgegengesetzt sind.

10. Mikroscanner nach einem der vorhergehenden Ansprüche, wobei ein Teil jedes der Cantilever (31 a, 31 b, 31 c, 31 d), auf dem ein zugehöriger Piezoaktuator angeordnet ist, dünner ist als andere Teile davon.

11. Mikroscanner nach einem der Ansprüche 1 bis 9, wobei der Teil jedes der Cantilever (31 a, 31 b, 31 c, 31 d), auf dem ein zugehöriger Piezoaktuator angeordnet ist, eingeschnitten ist.

12. Mikroscanner nach Anspruch 11, wobei der Piezoaktuator (30) eine Mehrschichtstruktur aufweist, in der ein erstes piezoelektrisches Bauteil (28a), eine zweite Elektrode (29a), ein zweites piezoelektrisches Bauteil (28b) und eine dritte Elektrode (29c) sequentiell auf einer ersten Elektrode (29b) aufgeschichtet sind.

13. Mikroscanner nach einem der vorhergehenden Ansprüche, wobei der Rahmen ein unteres Siliciumsubstrat (21), eine Isolierschicht (23), die auf dem unteren Siliciumsubstrat ausgebildet ist, und ein oberes Siliciumsubstrat (24), das auf der Isolierschicht ausgebildet ist, umfasst.

14. Mikroscanner nach Anspruch 12, wobei der Mikrospiegel (25), die beweglichen Kammelektroden (27) und die Cantilever (31) in der gleichen Ebene wie das obere Siliciumsubstrat (24) ausgebildet sind und die statischen Kammelektroden (22) in der gleichen Ebene wie das untere Siliciumsubstrat (21) ausgebildet sind.

15. Mikroscanner nach Anspruch 1, wobei die Cantilever (31) jeweils gegenüberliegende Seiten der horizontalen Antriebseinheit verbinden, um die horizontale Antriebseinheit zu tragen.

16. Mikroscanner nach Anspruch 15, wobei die Mehrzahl von Cantilevern umfasst:
erste und zweite Cantilever (31 a, 31 b), die sich parallel zueinander von einer ersten Seite des Rahmens erstrecken und die gegenüberliegenden Seiten der horizontalen Antriebseinheit verbinden, und
dritte und vierte Cantilever (31c, 31d), die sich parallel zueinander von einer zweiten Seite des Rahmens erstrecken und die gegenüberliegenden Seiten der horizontalen Antriebseinheit verbinden.

17. Mikroscanner nach Anspruch 16, wobei Abstände von Mittelpunkten der gegenüberliegenden Seiten der horizontalen Antriebseinheit (38) zum ersten und zweiten Cantilever (31 a, 31 b) jeweils gleich den Abständen von Mittelpunkten der gegenüberliegenden Seiten der horizontalen Antriebseinheit (38) zum dritten und vierten Cantilever (31 c, 31 d) sind.

18. Mikroscanner nach Anspruch 17, wobei der erste Cantilever (31 a) in die gleiche Richtung wie der zweite Cantilever (31 b) gebogen wird, der dritte Cantilever (31 c) in die gleiche Richtung wie der vierte Cantilever (31 d) gebogen wird und die Biegerichtungen des ersten und zweiten Cantilevers zu denen des dritten und vierten Cantilevers entgegengesetzt sind.

19. Mikroscanner nach Anspruch 15, wobei ein Teil jedes der Cantilever (31 a, 31 b, 31 c, 31 d), auf dem ein zugehöriger Piezoaktuator angeordnet ist, dünner ist als andere Teile davon.

20. Mikroscanner nach Anspruch 15, wobei der Teil jedes der Cantilever (31 a, 31 b, 31 c, 31 d), auf dem ein zugehöriger Piezoaktuator angeordnet ist, eingeschnitten ist.

21. Mikroscanner nach Anspruch 20, wobei der Piezoaktuator eine Mehrschichtstruktur aufweist, in der ein erstes piezoelektrisches Bauteil (28a), eine zweite Elektrode (29a), ein zweites piezoelektrisches Bauteil (28b) und eine dritte Elektrode (29c) sequentiell auf einer ersten Elektrode (29b) aufgeschichtet sind, und das erste piezoelektrische Bauteil eine zum zweiten piezoelektrischen Bauteil entgegengesetzte Polarisierungsrichtung aufweist.

22. Mikroscanner nach Anspruch 15, wobei der Rahmen ein unteres Siliciumsubstrat (21), eine Isolierschicht (23), die auf dem unteren Siliciumsubstrat ausgebildet ist, und ein oberes Siliciumsubstrat (24), das auf der Isolierschicht ausgebildet ist, umfasst.

23. Mikroscanner nach Anspruch 22, wobei der Mikrospiegel (25), die beweglichen Kammelektroden (27) und die Cantilever (31 a, 31 b, 31c, 31 d) in der gleichen Ebene wie das obere Siliciumsubstrat (24) ausgebildet sind und die statischen Kammelektroden (22) in der gleichen Ebene wie das untere Siliciumsubstrat (21) ausgebildet sind.

## Revendications

1. Microlecteur comprenant :
un cadre (37) ;
une unité d'entraînement horizontale (38) encadrant et comprenant
un micromiroir (25)
une pluralité d'électrodes-peigne verticales mobiles (27) formées parallèlement les unes aux autres le long des côtés opposés du micromiroir,
une pluralité d'électrodes-peigne verticales statiques (22) formées pour alterner avec les électrodes-peigne mobiles,
deux ressorts (26) disposés aux extrémités opposées du micromiroir et reliant les électrodes-peigne mobiles (27) et le micromiroir (25) à la pluralité d'électrodes-peigne verticales statiques (22), les électrodes-peigne verticales mobiles et les électrodes-peigne verticales statiques étant formées pour faire tourner le micromiroir autour d'un premier axe ; et
une unité d'entraînement verticale (39) comprenant une pluralité de bras en porte-à-faux (31a, 31b, 31c, 31d) s'étendant à partir du cadre (37) et reliant respectivement des côtés ou extrémités opposés de l'unité d'entraînement horizontale (38) pour soutenir l'unité d'entraînement horizontale, et
un actionneur piézoélectrique (30a, 30b, 30c, 30d) installé sur une surface supérieure de chacun des bras en porte-à-faux (31a, 31b, 31c, 31d), les bras en porte-à-faux (31a, 31b, 31c, 31d) étant agencés pour être inclinés vers le haut ou vers le bas selon que les actionneurs piézoélectriques se contractent ou se dilatent, les bras en porte-à-faux et les actionneurs piézoélectriques respectifs étant formés pour faire tourner l'unité d'entraînement horizontale autour d'un second axe qui est sensiblement perpendiculaire au premier axe.

2. Microlecteur selon la revendication 1, dans lequel les bras en porte-à-faux relient des extrémités opposées de l'unité d'entraînement horizontale.

3. Microlecteur selon la revendication 2, dans lequel la pluralité de bras en porte-à-faux comprend :
des premier et deuxième bras en porte-à-faux (31a, 31b) s'étendant respectivement à partir des côtés opposés du cadre et reliés à une première extrémité de l'unité d'entraînement horizontale ; et
des troisième et quatrième bras en porte-à-faux (31c, 31d) s'étendant respectivement à partir des côtés opposés du cadre et reliés à une seconde extrémité de l'unité d'entraînement horizontale (38).

4. Microlecteur selon la revendication 3, comprenant en outre :
un premier connecteur (32a) reliant une première extrémité de l'unité d'entraînement horizontale (38) et des extrémités en vis-à-vis des premier et deuxième bras en porte-à-faux (31a, 31b) et
un second connecteur (32b) reliant une seconde extrémité de l'unité d'entraînement horizontale (38) et des extrémités en vis-à-vis des troisième et quatrième bras en porte-à-faux (31c, 31d).

5. Microlecteur selon la revendication 3 ou 4, dans lequel le premier bras en porte-à-faux (31a) est agencé pour être incliné dans la même direction que le deuxième bras en porte-à-faux (31b), le troisième bras en porte-à-faux (31c) est agencé pour être incliné dans la même direction que le quatrième bras en porte-à-faux (31d), et les directions d'inclinaison des premier et deuxième bras en porte-à-faux sont opposées à celles des troisième et quatrième bras en porte-à-faux.

6. Microlecteur selon la revendication 2, dans lequel la pluralité de bras en porte-à-faux comprend :
des premier et troisième bras en porte-à-faux (31a, 31c) s'étendant perpendiculairement l'un à l'autre à partir d'un premier angle du cadre ; et
des deuxième et quatrième bras en porte-à-faux (31b, 31d) s'étendant perpendiculairement l'un à l'autre à partir d'un second angle du cadre et reliés de manière perpendiculaire respectivement aux premier et troisième bras en porte-à-faux.

7. Microlecteur selon la revendication 6, dans lequel une première extrémité de l'unité d'entraînement horizontale (38) est reliée à une partie de contact reliant les premier et deuxième bras en porte-à-faux (31a, 31b), et une seconde extrémité de l'unité d'entraînement horizontale est reliée à une partie de contact reliant les troisième et quatrième bras en porte-à-faux (31c, 31d).

8. Microlecteur selon la revendication 7, comprenant en outre :
un premier connecteur (32a) reliant une première extrémité de l'unité d'entraînement horizontale et la partie de contact reliant les premier et deuxième bras en porte-à-faux ; et
un second connecteur (32b) reliant une seconde extrémité de l'unité d'entraînement horizontale et la partie de contact reliant les troisième et quatrième bras en porte-à-faux.

9. Microlecteur selon la revendication 6, 7 ou 8, dans lequel le premier bras en porte-à-faux (31a) est agencé pour être incliné dans la même direction que le deuxième bras en porte-à-faux (31b), le troisième bras en porte-à-faux (31c) est agencé pour être incliné dans la même direction que le quatrième bras en porte-à-faux (31d), et les directions d'inclinaison des premier et deuxième bras en porte-à-faux sont opposées à celles des troisième et quatrième bras en porte-à-faux.

10. Microlecteur selon l'une quelconque des revendications précédentes, dans lequel une partie de chacun des bras en porte-à-faux (31a, 31b, 31c, 31d) sur laquelle est disposé un actionneur piézoélectrique correspondant est plus mince que d'autres parties de celui-ci.

11. Microlecteur selon l'une quelconque des revendications 1 à 9, dans lequel la partie de chacun des bras en porte-à-faux (31a, 31b, 31c, 31d) sur laquelle est disposé un actionneur piézoélectrique correspondant est découpée.

12. Microlecteur selon la revendication 11, dans lequel l'actionneur piézoélectrique (30) présente une structure à couches multiples dans laquelle un premier dispositif piézoélectrique (28a), une deuxième électrode (29a), un deuxième dispositif piézoélectrique (28b) et une troisième électrode (29c) sont empilés séquentiellement sur une première électrode (29b).

13. Microlecteur selon l'une quelconque des revendications précédentes, dans lequel le cadre comprend un substrat inférieur de silicium (21), une couche d'isolation (23) formée sur le substrat inférieur de silicium, et un substrat supérieur de silicium (24) formé sur la couche d'isolation.

14. Microlecteur selon la revendication 12, dans lequel le micromiroir (25), les électrodes-peigne mobiles (27) et les bras en porte-à-faux (31) sont formés dans le même plan que le substrat supérieur de silicium (24), et les électrodes-peigne statiques (22) sont formées dans le même plan que le substrat inférieur de silicium (21).

15. Microlecteur selon la revendication 1, dans lequel les bras en porte-à-faux (31) relient respectivement des côtés opposés de l'unité d'entraînement horizontale pour soutenir l'unité d'entraînement horizontale.

16. Microlecteur selon la revendication 15, dans lequel la pluralité de bras en porte-à-faux comprend :
des premier et deuxième bras en porte-à-faux (31a, 31b) s'étendant parallèlement l'un à l'autre à partir d'un premier côté du cadre et reliant les côtés opposés de l'unité d'entraînement horizontale ; et
des troisième et quatrième bras en porte-à-faux (31c, 31d) s'étendant parallèlement l'un à l'autre à partir d'un second côté du cadre et reliant les côtés opposés de l'unité d'entraînement horizontale.

17. Microlecteur selon la revendication 16, dans lequel les distances des centres des côtés opposés de l'unité d'entraînement horizontale (38) aux premier et deuxième bras en porte-à-faux (31a, 31b) sont respectivement égales aux distances des centres des côtés opposés de l'unité d'entraînement horizontale (38) aux troisième et quatrième bras en porte-à-faux (31c, 31d).

18. Microlecteur selon la revendication 17, dans lequel le premier bras en porte-à-faux (31a) est incliné dans la même direction que le deuxième bras en porte-à-faux (31b), le troisième bras en porte-à-faux (31c) est incliné dans la même direction que le quatrième bras en porte-à-faux (31d), et les directions d'inclinaison des premier et deuxième bras en porte-à-faux sont opposées à celles des troisième et quatrième bras en porte-à-faux.

19. Microlecteur selon la revendication 15, dans lequel une partie de chacun des bras en porte-à-faux (31a, 31b, 31c, 31d) sur laquelle est disposé un actionneur piézoélectrique correspondant est plus mince que d'autres parties de celui-ci.

20. Microlecteur selon la revendication 15, dans lequel la partie de chacun des bras en porte-à-faux (31a, 31b, 31c, 31d) sur laquelle est disposé un actionneur piézoélectrique correspondant est découpée.

21. Microlecteur selon la revendication 20, dans lequel l'actionneur piézoélectrique présente une structure à couches multiples dans laquelle un premier dispositif piézoélectrique (28a), une deuxième électrode (29a), un deuxième dispositif piézoélectrique (28b) et une troisième électrode (29c) sont empilés séquentiellement sur une première électrode (29b), et le premier dispositif piézoélectrique a une direction de polarisation opposée à celle du deuxième dispositif piézoélectrique.

22. Microlecteur selon la revendication 15, dans lequel le cadre comprend un substrat inférieur de silicium (21), une couche d'isolation (23) formée sur le substrat inférieur de silicium, et un substrat supérieur de silicium (24) formé sur la couche d'isolation.

23. Microlecteur selon la revendication 22, dans lequel le micromiroir (25), les électrodes-peigne mobiles (27) et les bras en porte-à-faux (31a, 31b, 31c, 31d) sont formés dans le même plan que le substrat supérieur de silicium (24), et les électrodes-peigne statiques (22) sont formées dans le même plan que le substrat inférieur de silicium (21).
